# EUROPÄISCHE PATENTSCHRIFT

(11) **EP 3 246 952 B1**
(45) Veröffentlichungstag und Bekanntmachung des Hinweises auf die Patenterteilung: **14.08.2019**
(21) Anmeldenummer: 17170878.7
(22) Anmeldetag: 12.05.2017
(51) Int. Cl.: H01L 29/06, H01L 29/417, H01L 21/8238, H01L 29/78

(54) **MOS-TRANSISTOR FÜR STRAHLENTOLERANTE DIGITALE CMOS-SCHALTUNGEN**
MOS TRANSISTOR FOR RADIATION-TOLERANT DIGITAL CMOS CIRCUITS
TRANSISTOR MOS POUR CIRCUITS CMOS NUMÉRIQUES TOLÉRANTS AUX RAYONNEMENTS

(30) Priorität: 19.05.2016 DE 102016208668
(43) Veröffentlichungstag der Anmeldung: 22.11.2017
(73) Patentinhaber: IHP GmbH - Innovations for High Performance Microelectronics / Leibniz-Institut für innovative Mikroelektronik, 15236 Frankfurt (Oder) (DE)
(72) Erfinder: Sorge, Roland, 15236 Frankfurt (Oder) (DE)
(74) Vertreter: Eisenführ Speiser

(56) Entgegenhaltungen:
- DE-B4- 19 735 425
- US-A1- 2006 113 602
- Fengying Qiao ET AL: "A PD-SOI based DTI-LOCOS combined cross isolation technique for minimizing TID radiation induced leakage in high density memory", Journal of Semiconductors, vol. 35, no. 2, 1 February 2014 (2014-02-01), page 024003, XP055490050, GB; CN ISSN: 1674-4926, DOI: 10.1088/1674-4926/35/2/024003

## Beschreibung

Die Erfindung betrifft einen monolithisch integrierter MOS-Transistor und eine monolithisch integrierte digitale MOS-Schaltung.

Digitale elektronische Schaltungen sind insbesondere bei Anwendung in der Luft- und Raumfahrt, in der Hochenergiephysik sowie in der Nuklearmedizin besonderen Strahlenbelastungen ausgesetzt. Ionisierende Strahlung bewirkt eine Änderung der Kanalleitfähigkeit eines MOS-Transistors infolge einer Influenzwirkung der in lateralen dielektrischen Isolatorschichten wie STI-Schichten (engl. shallow trench isolation) oder LOCOS-Schichten (engl. local oxidation of silicon) verhafteten positiven Löcherladung. Dies wird als TID-Effekt bezeichnet (engl. total ionizing dose). Der TID-Effekt bewirkt also unerwünschte, stark erhöhte Leckströme zwischen Source und Drain von MOS-Transistoren, die einer ionisierenden Strahlung ausgesetzt sind.

Zur Vermeidung von TID-Effekten ist es bekannt, ringförmige MOS-Transistoren (engl. enclosed layout transistor, ELT) zu verwenden. Eine ringförmige Konstruktion des MOS-Gates, welches Source und Drain voneinander trennt, vermeidet Änderungen der Kanalleitfähigkeit von MOS-Transistoren durch TID-Effekte. Ein Nachteil von ELT-MOS-Ringtransistoren ist jedoch, dass technologisch mögliche minimale Gate-Weiten nicht realisierbar sind. Die Struktur solcher Transistoren weist darüber hinaus eine große Asymmetrie auf, mit großen Unterschieden in den Source- und Drain-Flächen. Schließlich haben solche Transistorstrukturen einen deutlich größeren Flächenverbrauch im Vergleich zu einer Transistoranordnung mit einem linearen MOS-Transistor-Layout.

Aus der Veröffentlichung US 2006/0113602 A1 ist eine MOS-Schaltungsanordnung bekannt, die ein Silizum-Substrat, einen Transistor, eine Feldoxidschicht und eine Polysilizum-Schutzschicht aufweist. Die Feldoxidschicht ist in einem Abstand von einer Source- oder Drainelektrode angeordnet und bildet ein aktives Gebiet zwischen der Feldoxidschicht und dem Transistor. Auf dem aktiven Gebiet ist die Polysilizium-Schutzschicht angeordnet, um das Feldoxidgebiet mit dem Source- bzw. Drain-Gebiet zu verbinden und einen Durchbruchspfad für einen Durchbruch zwischen dem Transistor und dem Siliziumsubstrat bereitzustellen, um eine Durchbruchsspannung des Transistors zu erhöhen.

Das Dokument DE 197 35 425 B4 beschreibt einen MOSFET mit einem Halbleitersubstrat mit darin ausgebildeter Source und Drain sowie mit einem ringförmig zur Source angeordneten Gate, wobei die ringförmige Drain die Source konzentrisch umgibt und hiermit einen Kanal bildet, sowie mit einem umgebenden Feldoxidbereich. Es ist ein Polysiliziumring vorgesehen ist, der die Drain vom Feldoxidbereich isoliert, wobei der Innenrand des Polysiliciumrings überlappend zum Außenrand der Drain ist.

Fengying Qiao et al. "A PD-SOI based DTI-LOCOS combined cross isolation technique for minimizing TID radiation induced leakage in high density memory", Journal of Semiconductors, Februar 2014, Seite 024003-1 bis 024003-6 offenbart einen integrierten strahlungstoleranten MOS-Transistor.

Gemäß einem Aspekt der vorliegenden Erfindung wird ein monolithisch integrierter MOS-Transistor vorgeschlagen, aufweisend
- ein dotiertes Wannengebiet eines ersten Leitfähigkeitstyps;
- ein im Wannengebiet ausgebildetes aktives MOS-Transistor-Gebiet, mit dotierten Source- und Drain-Gebieten eines zweiten Leitfähigkeitstyps und mindestens einem MOS-Kanal-Gebiet, welches sich zwischen den Source-und Drain-Gebieten unter einem jeweiligen Gate-Stapel erstreckt;
- eine an das aktive MOS-Transistor-Gebiet angrenzende und dieses lateral allseitig umgebende dielektrische Isolationsschicht vom Typ STI oder LOCOS, wobei
- Wannenabschnitte des Wannengebiets an das MOS-Kanal-Gebiet in beiden einander entgegengesetzten lateralen Längsrichtungen, die senkrecht zu einer gedachten Verbindungslinie weisen, welche vom Source- durch das MOS-Kanal-Gebiet zum Drain-Gebiet reicht, an das MOS-Kanal-Gebiet anschließen und bis zu einer Oberfläche des aktiven MOS-Transistor-Gebiets reichen, wodurch der an das MOS-Kanal-Gebiet anschließende jeweilige Wannenabschnitt zwischen dem MOS-Kanal-Gebiet und der dielektrischen Isolationsschicht angeordnet ist, wobei die Tiefenerstreckung der Wannenabschnitte stets größer als eine Tiefenerstreckung der angrenzenden dielektrischen Isolationsschicht ist.

Dem erfindungsgemäßen MOS-Transistor liegen unter anderem die nachfolgend erläuterten Erkenntnisse zugrunde:
Bei bekannten MOS-Transistoren, welche ionisierender Strahlung ausgesetzt wurden, tritt wie erläutert eine Änderung der Kanalleitfähigkeit durch eine Influenzwirkung der in den lateral in Längsichrichtung angrenzenden dielektrischen Isolationsschichten (STI- oder LOCOS-Isolation) verhafteten positiven Ladung auf. Für einen NMOS-Transistor ergibt sich dadurch eine erhöhte Kanalleitfähigkeit aufgrund der Anreicherung von Majoritätsladungsträgen, d.h. Elektronen im Kanalgebiet. Dies führt zu einer unerwünschten Anhebung des Leckstrom-Niveaus. Für einen PMOS Transistor ergibt sich dagegen eine erniedrigte Kanalleitfähigkeit durch die Verarmung von Majoritätsladungsträgen, d.h. Löchern, im Kanalgebiet.

Bei dem erfindungsgemäßen MOS-Transistor werden derartige unerwünschte Änderungen der Kanalleitfähigkeit dadurch vermieden, dass zwischen dem MOS-Kanal-Gebiet und den lateral in Längsrichtungen benachbarten dielektrischen Isolationsgebieten Sperrabschnitte mittels zusätzlich eingefügter lateraler Abschnitte des Wannengebiets geschaffen werden, die hier als Wannenabschnitte bezeichnet werden. Diese Wannenabschnitte des dotierten Wannengebiets schließen sich beidseitig lateral, in quer zur Stromflussrichtung im MOS-Kanal-Gebiet weisender Längsrichtung, an das MOS-Kanal-Gebiet an und reichen dort bis zur Oberfläche des aktiven MOS-Transistor-Gebiets. Der sich jeweils lateral an das MOS-Kanal-Gebiet anschließende Wannenabschnitt ist zwischen dem MOS-Kanal-Gebiet und der dortigen, zum aktiven MOS-Transistor-Gebiet hingewandten Innenseite der dielektrischen Isolationsschicht angeordnet.

Diese Wannenabschnitte können auch als sperrschichtisolierende Wannenabschnitte bezeichnet werden. Denn eine vorteilhafte Sperrwirkung ist durch einen sich von selbst einstellenden Potentialunterschied zwischen dem jeweiligen Wannenabschnitt und dem MOS-Kanal-Gebiet stets gegeben, ohne dass zusätzlich eine Spannung angelegt werden muss. Dadurch bleiben Festladungsänderungen an den lateralen Grenzflächen zwischen dem jeweiligen Wannenabschnitt und dem dielektrischem Isolationsgebiet ohne Wirkung auf das MOS-Kanal-Gebiet und somit auf die elektrischen Parameter des MOS-Transistors. Mit anderen Worten, der Inversionskanal im Kanal-Gebiet "spürt" aufgrund des lateral angrenzenden sperrschichtisolierenden Wannenabschnitts keine Festladungsänderungen an der Grenzfläche zum dielektrischen Isolationsgebiet. Auf diese Weise gelingt eine Unterdrückung der vom TID-Effekt versursachten unerwünschten Änderungen der Kanalleitfähigkeit von MOS-Transistoren.

Die beiden einander entgegengesetzten Längsrichtungen weisen also quer zur Stromflussrichtung im MOS-Kanal. Sie werden im Rahmen der vorliegenden Beschreibung der Einfachheit halber auch als "die Längsrichtung" zusammengefasst, es sei denn, im jeweiligen Kontext kommt es darauf an, zwischen diesen beiden Längsrichtungen zu unterscheiden.

Nachfolgend werden Ausführungsbeispiele des erfindungsgemäßen MOS-Transistors beschrieben.

Der erfindungsgemäß vorgeschlagene MOS-Transistor erlaubt im Gegensatz zu den im Stand der Technik beschriebenen MOS-Ringtransistoren (ELT, enclosed layout transistor) die Herstellung von Ausführungsformen mit linearen Gatestrukturen. Bei solchen Ausführungsformen mit linearen Gatestrukturen verlaufen der Gatestapel und das MOS-Kanalgebiet in der Längsrichtung geradlinig. Dies hält den Flächenbedarf von strahlungstoleranten integrierten digitalen Speicher- oder Logik-Schaltungen gering, die solche MOS-Transistoren typischerweise in sehr großer Anzahl enthalten. Besonders platzsparende Varianten dieser Ausführungsformen weisen minimale Kanalbreiten auf, die allein durch das Skalierungsniveau einer jeweiligen CMOS-Technologie bestimmt sind.

Die laterale Ausdehnung der sperrschichtisolierenden Wannenabschnitte in Längsrichtung (mit anderen Worten: die Breite) beiderseits des Kanal-Gebiets kann auf ein geringes Maß beschränkt werden. Sinnvollerweise wird ein zur Unterdrückung des TID-Effektes gerade ausreichendes Mindestmaß gewählt, um den Flächenbedarf des MOS-Transistors so gering wie möglich zu halten. Eine solche minimale notwendige Ausdehnung der sperrschichtisolierenden Wannenabschnitte im aktiven MOS-Transistorgebiet ist vom jeweiligen Skalierungsniveau der verwendeten MOS-Technologie abhängig. Vorzugsweise beträgt die laterale Ausdehnung der Wannenabschnitte in Längsrichtung jeweils zwischen 10und 500 Nanometer. So hat sich beispielsweise für NMOS Transistoren in einer 0,25µm-CMOS-Technologie ein Mindestmaß von 0,4 µm als ausreichend erwiesen. Bei einer Technologie mit höherem Skalierungsniveau, also geringeren Stegbreiten, kann dieses Mindestmaß reduziert werden. Es liegt typischerweise etwa um das 1,5-fache über der Stegbreite der verwendeten Technologie. In manchen Ausführungsformen ist die Breite der sperrschichtisolierenden Wannenabschnitte an beiden Längsenden des Kanalgebiets gleich. In anderen Ausführungsform ist sie an beiden Längsenden des Kanalgebiets unterschiedlich.

Eine Tiefenerstreckung der Wannenabschnitte ist größer als eine Tiefenerstreckung der angrenzenden dielektrischen Isolationsschicht, da die Wannenabschnitte Teil der Wannengebiets sind und somit dieselbe Tiefenerstreckung wie das Wannengebiet selbst haben. Das Wannengebiet hat eine größere Tiefenerstreckung als die dielektrische Isolationsschicht, die ja in einer Ausführungsvariante ausdrücklich auch als "flache" (shallow) Isolationsschicht bezeichnet wird.

In manchen Ausführungsformen wird ein zusätzlicher sperrschichtisolierender Wannenabschnitt des Wannengebiets eingesetzt, der in Verlängerung der gedachten Verbindungslinie vom Source-Gebiet zum Drain-Gebiet bis zur Oberfläche des aktiven MOS-Transistor-Gebiets reicht. Dieser zusätzliche Wannenabschnitt des Wannengebiets ist also zwischen dem Source-Gebiet und dem Drain-Gebiet und der dielektrischen Isolationsschicht angeordnet ist. Dieser zusätzlicher sperrschichtisolierende Wannenabschnitt sorgt für eine laterale Isolation auch des Source- bzw. Drain-Gebiets eines MOS Transistors zu den Source- Drain-Gebieten benachbarter MOS Transistoren.

Bei bevorzugten Ausführungsformen ist die Oberfläche des aktiven MOS-Transistorgebiets über dem jeweiligen sperrschichtisolierenden Wannenabschnitt mit einer Silizid-Blocker-Schicht aus einem elektrisch isolierenden Material bedeckt. Diese verhindert eine Silizidbildung in diesen Gebieten, die in manchen Herstellungsprozessen unerwünscht auftreten kann. Auf diese Weise werden Kurzschlüsse an der Oberfläche in den sperrschichtisolierten Gebieten des MOS Transistors vermieden.

In Weiterbildung des erfindungsgemäßen MOS-Transistors wird gemäß einem zweiten Aspekt der Erfindung eine monolithisch integrierte digitale MOS-Schaltung vorgeschlagen, welche mindestens einen MOS-Transistor gemäß einer der Ausführungsformen des ersten Aspekts vorliegenden Erfindung und mindestens ein weiteres monolithisch integriertes Bauelement aufweist. Ein solches weiteres monolithisch integriertes Bauelement kann auch ein weiterer erfindungsgemäßer MOS-Transistor sein. Eine solche monolithisch integrierte digitale MOS-Schaltung enthält also Schaltungszellen, welche mindestens einen MOS-Transistor gemäß dem ersten Aspekt oder eine seiner Ausführungsformen aufweist. Diese MOS-Schaltung teilt entsprechend die Vorteile des MOS-Transistors des ersten Aspekts der Erfindung.

Bevorzugte Ausführungsformen der MOS-Schaltung des zweiten Aspekts sind zusätzlich gegen den SET- und den SEU-Effekt geschützt. Diese unerwünschten Effekte werden nachfolgend zunächst erläutert. Anschließend wird auf bekannte Schaltungen zur Vermeidung dieser unerwünschten Effekte eingegangen, bevor in diesem Kontext vorteilhafte Merkmale der bevorzugten Ausführungsformen der MOS-Schaltung des zweiten Aspekts erläutert werden.

Eine Bestrahlung mit geladenen schweren und energiereichen Teilchen kann in einer digitalen Schaltung in MOS-Bauelement-Regionen zusätzlich an in Sperrrichtung gepolten pn-Übergängen eine starke Erzeugung von Elektron-Loch-Paaren bewirken. Die damit verbundene starke Erhöhung von Wannenströmen führt zu einer starken lokalen Potentialänderung im jeweiligen Wannengebiet, insbesondere in der Umgebung betroffener MOS-Source-Gebiete. Diese lokalen Potentialänderungen sind umso größer, je größer ein Anschlusswiderstand der Wannengebiete zu VDD bzw. Vss ist. Dadurch werden Basis-Emitter-pn-Übergänge von parallel zu Drain- und Source-Gebieten des MOS-Transistors liegenden parasitären Bipolartransistoren in Flussrichtung vorgespannt. Die dadurch bedingten kurzzeitigen (transienten) Einschaltvorgänge der zwischen Drain- und Source-Gebieten der MOS Transistoren liegenden parasitären Bipolartransistoren bewirken eine kurzzeitige Änderung des logischen Signalpegels am Ausgang eines betreffenden logischen Gatters. Dieser Effekt wird als SET bezeichnet (englisch: single event transient). Durch diesen Verlust der Sperrfähigkeit von MOS Transistoren kommt es zu einer kurzzeitigen Fehlfunktion an den Ausgängen digitaler kombinatorischer Schaltungen. Wird ein solches SET-Signal in kombinatorischen Schaltungsteilen weiter durchgeschaltet und letztlich in Registern wie Latches oder Flip Flops gespeichert (SEU, englisch: single event upset), so wird der logische Zustand einer digitalen Schalung auf Dauer fehlerhaft verändert. Fehlfunktionen in digitalen Schaltungen werden also zusammenfassend auch hervorgerufen durch SET/SEU-Effekte, nämlich den Verlust der Gatesteuerung von MOS Transistoren, hervorgerufen durch Ein- und Ausschaltvorgänge von parallel zu Drain- und Source-Gebieten liegenden parasitären Bipolartransistoren bei einer Bestrahlung mit hochenergetischen schweren geladenen Teilchen.

Monolithisch integrierte digitale MOS-Schaltungen, die diese Effekte reduzieren, sind beispielsweise aus folgenden Veröffentlichungen bekannt:
(1) Johan Walldén "Radiation Induced Effects in Electronic Devices and Radiation Hardening By Design Techniques", University Linköping, Electronic Components Department of Electrical Engineering, SE-581 83 Linköping, SRN LiTH-ISY-EX--14/4771-SE, 2014-06-13. Diese Veröffentlichung wird nachfolgend mit (1) bezeichnet.
(2) "Space Product Assurance - Technique for Radiation Effects Mitigation in ASICs and FPGAs Handbook", ECSS Standard, Draft, 30 October 2015, ESA Requirements and Standards Division, ESTEC, P.O. Box 299, 2200 AG Noordwijk, The Netherlands. Diese Veröffentlichung wird nachfolgend mit (2) bezeichnet.
(3) "CMOS circuits with protection for a single event upset", EP1 387 494 A1. Diese Veröffentlichung wird nachfolgend mit (3) bezeichnet.

Wie in den zitierten Veröffentlichungen (1) und (2) ausgeführt ist, versucht man die Zuverlässigkeit von digitalen CMOS-Schaltungen bei Bestrahlung mit hochenergetischen schweren Ionen durch Einfügen von Redundanz auf der Schaltungsebene und auf der Systemebene zu verbessern. Auf der Schaltungsebene werden Ansätze wie "triple mode redundancy" (TMR) und "dual interlocked storage cells" (DICE) verfolgt, um die Empfindlichkeit gegenüber SET-Effekten zu reduzieren. Auf Systemebene wird versucht, durch redundante Anordnung von Prozessorkernen und durch Fehlerkorrekturalgorithmen die Fehlertoleranz zu verbessern. Das Einfügen von Redundanz auf Schaltungs- und Systemebene erhöht jedoch den Flächenbedarf des Schaltungslayouts besonders stark, steigert den Leistungsbedarf der Schaltung und fordert einen großen System-Overhead in Bezug sowohl auf Hardware als auch auf Software.

Alternativ dazu wird in der Veröffentlichung (3) eine Redundanz auf Transistorebene ausgeführt.

Mit wesentlichen, nachfolgend erläuterten Erweiterungen machen Ausführungsformen der erfindungsgemäßen MOS-Schaltung zur Vermeidung von SEU-Effekten von diesem an sich bekannten Schaltungsprinzip der Redundanz auf Transistorebene Gebrauch, und zwar im NMOS-Pfad oder im PMOS-Pfad, vorzugsweise jedoch sowohl im NMOS-Pfad als auch im PMOS-Pfad. Mit anderen Worten, jede schaltungstechnische NMOS-Transistorfunktion oder (im Sinne von und/oder) jede schaltungstechnische PMOS-Transistorfunktion ist in Form einer dualen MOS-Transistorstruktur ausgeführt. Bei der erfindungsgemäßen MOS-Struktur zur Vermeidung von SEU-Effekten, die im folgendem als Common-Gate-MOS-Transistorstruktur bezeichnet wird, erreicht man im Unterschied zu der in der Veröffentlichung (3) aufgeführten dualen MOS-Transistorstruktur durch besondere konstruktive Maßnahmen eine wesentliche Verringerung des Wannenanschlusswiderstandes nach VDD bzw. VSS, was eine Verkürzung von SET-Ereignissen bewirkt und dadurch maßgeblich zur Vermeidung von SEU-Ereignissen beiträgt. Eine Common-Gate-MOS-Transistorstruktur enthält zwei in Reihe geschaltete MOS-Transistoren gemäß dem ersten Aspekt der Erfindung oder einer der erläuterten Ausführungsformen. Diese zwei MOS-Transistoren sind vom identischen Leitungstyp und sind über eine gemeinsame Gate-Elektrode verbunden. Die Source- und Drain-Gebiete der beiden räumlich voneinander separierten MOS-Transistoren sind nicht miteinander verschmolzen, sondern über eine metallische Leitbahn in einer Reihenschaltung miteinander verbunden. Diese duale MOS-Transistorstruktur entspricht einer UND-Funktionalität.

In einer bevorzugten Variante besteht die Common-Gate-MOS-Transistorstruktur aus zwei solchen MOS-Transistoren gemäß dem ersten Aspekt der Erfindung. Eine solche Struktur wird vorliegend auch als junction-isolated-common-gate(JICG)-MOS-Transistorstruktur bezeichnet.

In manchen Ausführungsbeispielen ist jede schaltungstechnische NMOS-Transistorfunktion und jede schaltungstechnische PMOS-Transistorfunktion der MOS-Schaltung des zweiten Aspekts der Erfindung in Form einer solchen JICG-MOS-Transistorstruktur ausgeführt. Es ist dann für einen gegebenen herkömmlichen Schaltplan einer Schaltung, beispielsweise für ein CMOS-Gatter, ein jeweiliger herkömmlicher, nicht SEU- und nicht TID-geschützter MOS-Transistor im Schaltplan durch die JICG-MOS-Transistorstruktur ersetzt, also durch in Reihe geschaltete erfindungsgemäße MOS-Transistoren gleichen Typs, deren Gates miteinander verbunden sind.

Die MOS-Transistoren der JICG-MOS-Transistorstruktur sind vorzugsweise in einem gemeinsamen aktiven MOS-Transistor-Gebiet ausgebildet. Vorteilhafte Ausführungsformen dieser JICG-MOS-Transistorstruktur zeichnen sich neben den vorteilhaften Merkmalen des MOS-Transistors des ersten Aspekts der Erfindung dadurch aus, dass zur Unterdrückung von SET- und SEU-Effekten eine niederohmige Ableitung von Majoritätsladungsträgerströmen in den Wannengebieten ermöglicht ist. Dies wird dadurch erreicht, dass die JICG-MOS-Transistorstruktur sowohl ein erstes Wannenschlussgebiet an einem der Längsenden des Wannengebiets als auch ein zweites Wannenanschlussgebiet zwischen den Source- oder Drain-Gebieten eines ersten der beiden MOS-Transistoren und den Source- oder Drain-Gebieten eines zweiten der beiden MOS-Transistoren der Common-Gate-MOS-Transistorstrukturaufweist. Somit sind alle (im Betrieb sperrgepolten) Source-und Drain-Gebiete der beiden MOS-Transistoren von den zugehörigen Wannenanschlussgebieten, welche sich bis zur Oberfläche erstrecken, umgeben. Vorzugsweise hat das zwischen den beiden räumlich voneinander separierten MOS-Transistoren der JICG-MOS-Transistorstrukturvorgesehene zweite Wannenanschlussgebiet in der Längsrichtung etwa dieselbe Ausdehnung wie die Source-Drain Gebiete der beiden MOS-Transistoren. Die Ausdehnung kann auch etwas größer sein. Mit den in diesem Absatz genannten zusätzlichen Merkmalen - die jeweils für sich genommen implementiert sein können, bevorzugt jedoch kumulativ implementiert sind - gelingt es, besonders kurze SET-Ereignisse zu erzielen, indem die Anschlusswiderstände der Wannengebiete zu VDD bzw. VSS besonders gering gehalten werden. Dies gilt sowohl für Ausführungsformen, die ein N-Wannengebiet verwenden, als auch solche, die ein P-Wannengebiet verwenden. Der Anschlusswiderstand bezieht sich auf die Anschlüsse zu VDD für JICG-PMOS- und VSS für JICG-NMOS-Transistorstrukturen.

In vorteilhaften Ausführungsformen der MOS-Schaltung reicht in einem der MOS-Transistoren der Common-Gate-MOS-Transistorstruktur ein zweiter zusätzlicher Wannenabschnitt des Wannengebiets in Verlängerung der gedachten Verbindungslinie vom Source-Gebiet zum Drain-Gebiet bis zu einer Oberfläche des aktiven MOS-Transistor-Gebiets, wobei der zusätzliche Wannenabschnitt des Wannengebiets zwischen dem Source-Gebiet oder dem Drain-Gebiet und dem (zweiten) Wannenschlussgebiet angeordnet ist

Ein Abstand von Gebieten der beiden MOS-Transistoren der JICG-MOS-Transistorstruktur, die im Betrieb in Sperrrichtung vorgespannt sind, ist im Layout vorzugsweise so groß gewählt, dass bei einem Einschlag eines einzelnen schweren Ions mit hoher Energie ein SET-Effekt nur jeweils einer der beiden MOS Transistoren betroffen ist. Der Abstand ist also größer als ein energieabhängiger Wirkradius einer generierten Wolke von Elektron-Loch-Paaren, die bei einem Teilcheneinschlag in einem MOS-Transistor der JICG-MOS-Transistorstrukturerzeugt wird. Bevorzugt sind dafür die Source-Draingebiete der MOS-Transistoren der JICG-MOS-Transistorstrukturmit einem lateralen Abstand in Richtung der Verbindungslinie von einander angeordnet, der mindestens zehn Mal größer ist als eine durch eine verwendete Herstellungstechnologie erzielbare vorbestimmte minimale Gatelänge. Für eine in einer 0,25µm-CMOS Technologie realisierte 1024 stufige CMOS-Inverterkette wurde für einen Abstand der Draingebiete in JICG-NMOS-Transistorstrukturen von 4,1 µm bei einem lokalen Energietransfer von 67,9 MeV cm²/mg mit Xenon-Ionen in das Siliziumsubstrat das Ausbleiben von SEU-Ereignissen experimentell nachgewiesen. Dies ist ein herausragendes Ergebnis.

Die in JICG-MOS-Transistorstrukturen durch die verbundenen Gates der in Reihe geschalteten MOS-Transistoren realisierte UND-Funktionalität hat zur Folge, dass die Sperrfähigkeit immer bei mindestens einem der beiden Transistoren erhalten bleibt, wodurch die aus dem Stand der Technik bekannten Fehlfunktionen von CMOS-Gattern durch SET-Effekte vermieden werden.

Nachfolgend werden weitere Ausführungsbeispiele anhand der Figuren erläutert. Es zeigen:
- Fig. 1: ein Layout eines Ausführungsbeispiels eines MOS-Transistors gemäß der vorliegenden Erfindung;
- Fig. 2: eine Querschnittsansicht des Ausführungsbeispiels der Figur 1 entlang der Linie II-II';
- Fig. 3: eine Querschnittsansicht des Ausführungsbeispiels der Figur 1 entlang der Linie III-III'
- Fig.4: eine Längsschnittansicht des Ausführungsbeispiels der Figur 1 entlang der Linie IV-IV';
- Fig.5: eine Längsschnittansicht des Ausführungsbeispiels der Figur 1 entlang der Linie V-V';
- Fig. 5A: eine Längsschnittansicht des Ausführungsbeispiels der Figur 1 entlang der Linie VI-VI';
- Fig.6: ein für sich genommen bekanntes Schaltbild einer CMOS-Inverter-Schaltung zur Erläuterung des Ausführungsbeispiels der Fig.7;
- Fig.7: ein Layout eines Ausführungsbeispiels einer CMOS-Inverter-Schaltung gemäß der vorliegenden Erfindung;
- Fig.8: eine Querschnittsansicht des Ausführungsbeispiels der Figur 7 entlang der Linie VIII-VIII'; und
- Fig. 9: eine Querschnittsansicht des Ausführungsbeispiels der Figur 7 entlang der Linie IX-IX'.

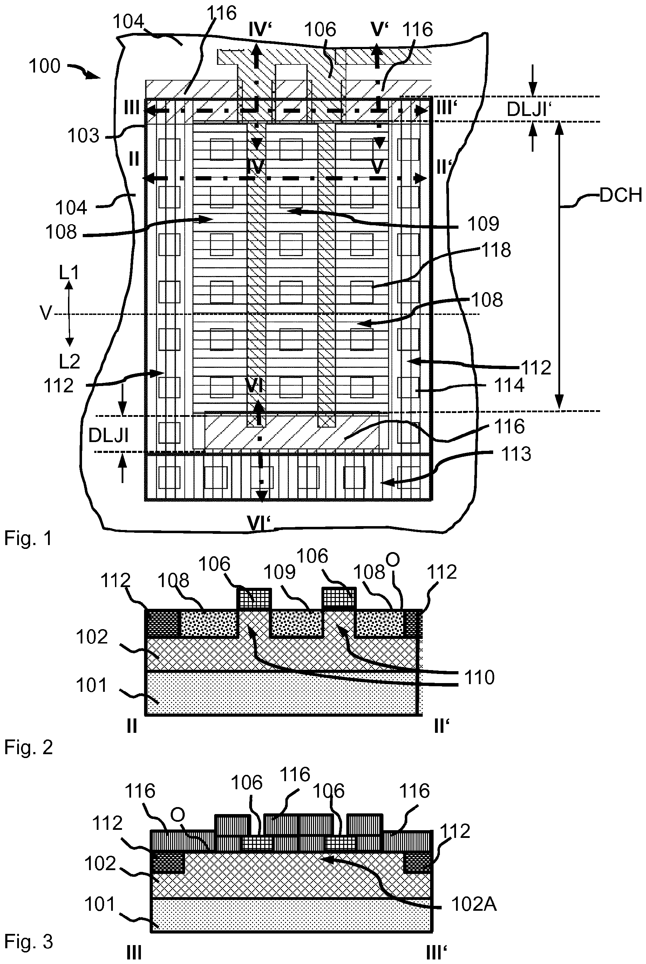

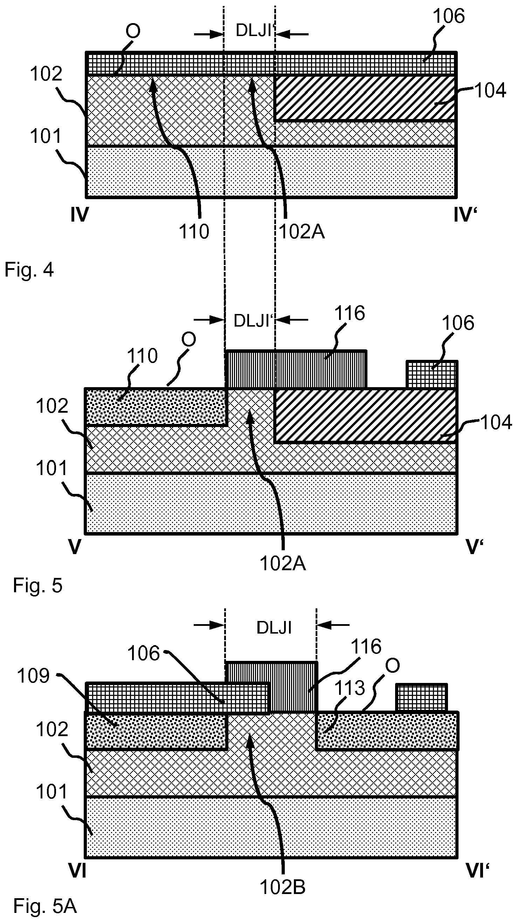

Nachfolgend wird auf die Figuren 1 bis 5 und 5A parallel Bezug genommen. Fig. 1 ist eine Layout-Ansicht eines Ausführungsbeispiels eines MOS-Transistors gemäß der vorliegenden Erfindung. Die Figuren 2 bis 5 und 5A zeigen unterschiedliche Schnittansichten dieses MOS-Transistors. Fig. 2 ist eine Querschnittsansicht des Ausführungsbeispiels der Figur 1 entlang der Linie II-II'. Fig. 3 ist eine Querschnittsansicht des Ausführungsbeispiels der Figur 1 entlang der Linie III-III'. Fig. 4 zeigt eine Längsschnittansicht des Ausführungsbeispiels der Figur 1 entlang der Linie IV-IV'. Fig. 5 zeigt eine Längsschnittansicht des Ausführungsbeispiels der Figur 1 entlang der Linie V-V'. Fig. 5A schließlich zeigt eine Längsschnittansicht des Ausführungsbeispiels der Figur 1 entlang der Linie VI-VI'.

Das in Figur 1 dargestellte Layout eines NMOS-Transistors 100 auf einem P-dotierten Siliziumsubstrat 101 sieht ein aktives MOS-Transistorgebiet 103 vor, welches allseitig von einer flachen dielektrischen Isolationsschicht 104 vom Typ STI oder LOCOS umgeben ist. Das aktive MOS- Transistorgebiet 103 ist in einem P-dotierten Wannengebiet 102 ausgebildet. Das Wannengebiet 102 erstreckt sich lateral an allen Seiten auch unter dem flachen dielektrischen Isolationsgebiet (Feldoxidgebiet) 104, welches in den Schnittansichten der Figuren 2 und 3 nicht extra dargestellt ist. Jedoch zeigen dies die Längsschnittansichten der Figuren 4 und 5 deutlich.

Vorliegend handelt es sich um einen Feldeffekt-Transistor mit einem zweifingrigen Gate. Es sind jedoch auch andere, an sich bekannte Transistorstrukturen mit mehr oder weniger als zwei Gate-Fingern für die Verwendung in einer erfindungsgemäßen Transistorstruktur geeignet. Unter einem hier also zweifingrigen Gate (schräge Schraffur in Fig. 1) und einem in den Schnittzeichnungen nicht näher ausgeführten Gate-Stapel 106 erstreckt sich ein jeweiliges lineares MOS-Kanalgebiet 110 in einer Längsrichtung. Die beiden entgegengesetzten Längsrichtungen sind in Fig. 1 mit Pfeilen L1 und L2 gekennzeichnet. Die MOS-Kanalgebiete 110 sind jeweils zwischen einem jeweiligen dotierten Source-Gebiet 108 und einem mittig liegenden dotierten Drain-Gebiet 109 (horizontale Schraffur in Fig. 1) angeordnet. An 3 Seiten hat das aktive MOS- Transistorgebiet 103 Wannenanschlussgebiete 112 und 113.

Im vorliegenden Ausführungsbeispiel hat der MOS-Transistor zur Vermeidung des TID-Effektes Wannenabschnitte 102A des Wannengebiets 102, die an das MOS-Kanal-Gebiet 110 in beiden einander entgegengesetzten lateralen Längsrichtungen L1, L2 anschließen und bis zu einer Oberfläche (auch als Oberseite bezeichnet) O des aktiven MOS-Transistor-Gebiets 103 reichen (siehe Fig.4). Dadurch ist also der an das MOS-Kanal-Gebiet 110 anschließende jeweilige Wannenabschnitt 102A mit der Breite DLJI zwischen dem MOS-Kanal-Gebiet 110 und der dielektrischen Isolationsschicht 104 angeordnet. Im vorliegenden Ausführungsbeispiel ist zusätzlich das Wannenanschlussgebiet 113 zwischen dem Wannenabschnitt 102A und der dielektrischen Isolationsschicht 104 angeordnet. Dies ist in einer CMOS-Schaltung zwar eine technisch sinnvolle und daher bevorzugte Lösung zur Kontaktierung einer Vielzahl von Bauelementen auf einem Substrat. Es handelt dabei sich jedoch nicht um eine für die Vermeidung des TID-Effektes wesentliche Maßnahme, sondern um eine Option. Andere Ausführungsbeispiele, die hier nicht dargestellt sind, weisen das Wannenanschlussgebiet 113 nicht auf. Dort grenzt der Wannenabschnitt 102A also direkt an das dielektrische Isolationsgebiet 104.

Eine Kanalbreite DCH des MOS-Transistors wird bei der Herstellung des vorliegenden MOS-Transistors 100 nicht, wie in CMOS-Technologien sonst üblich, durch die Breite des aktiven Transistor-Gebiets 103 eingestellt, sondern durch eine lithographische Breite einer Öffnung einer Source/Drain-Maske (nicht dargestellt), mit Hilfe derer die Source/Drain-Gebiete dotiert werden.

Bei dem MOS-Transistor 100 werden unerwünschte Änderungen der Kanalleitfähigkeit infolge einer Einwirkung ionisierender Strahlung also dadurch vermieden, dass zwischen dem MOS-Kanal-Gebiet 110 und den lateral in Längsrichtungen benachbarten dielektrischen Isolationsgebieten 104 mittels zusätzlich eingefügter lateraler Wannenabschnitte 102A des Wannengebiets 102 geschaffen werden. Diese Wannenabschnitte 102A des dotierten Wannengebiets 102 schließen an das MOS-Kanal-Gebiet 110 an seinem jeweiligen Längsende an. Sie reichen dort, wie in Fig. 3 bis Fig. 5 zu sehen ist, bis zur Oberfläche O des aktiven MOS-Transistor-Gebiets 103. Dadurch ist der am jeweiligen Längsende des MOS-Kanal-Gebiets 110 anschließende jeweilige Wannenabschnitt 102A zwischen dem MOS-Kanal-Gebiet 110 und der dortigen, zum aktiven MOS-Transistor-Gebiet hingewandten Innenseite der dielektrischen Isolationsschicht 104 angeordnet.

Diese Wannenabschnitte 102A werden hier auch als sperrschichtisolierende Wannenabschnitte bezeichnet. Denn eine vorteilhafte Sperrwirkung ist durch einen sich von selbst einstellenden Potentialunterschied zwischen dem jeweiligen Wannenabschnitt 102A und dem MOS-Kanal-Gebiet 110 stets gegeben, ohne dass zusätzlich eine Spannung angelegt werden muss. Dadurch bleiben Festladungsänderungen an den lateralen Grenzflächen zwischen dem Halbleitermaterial des MOS-Kanal-Gebiets und dem dielektrischem Isolationsgebiet 104 ohne Wirkung auf das MOS-Kanal-Gebiet und somit auf die elektrischen Parameter des MOS-Transistors 100. Ein Inversionskanal im MOS-Kanal-Gebiet 110 "spürt" also aufgrund des lateral angrenzenden sperrschichtisolierenden Wannenabschnitts 102A keine Festladungsänderungen an der Grenzfläche zum dielektrischen Isolationsgebiet 104. Auf diese Weise gelingt eine Unterdrückung der vom TID-Effekt versursachten unerwünschten Änderungen der Kanalleitfähigkeit des MOS-Transistors 100.

Die Ausdehnung der eingefügten Wannenabschnitte 102A in Längsrichtung ist in Fig. 1, Fig. 5 und Fig. 5A mit DLJI bzw. DLJI' gekennzeichnet. Ihr technisch zur Erzielung der erläuterten Abschirmungswirkung erforderlicher Minimalwert ist vom Skalierungsniveau der zur Herstellung verwendeten MOS-Technologie abhängig. Er liegt je nach Skalierungsniveau zwischen 10 und etwa 500 Nanometer. So hat sich beispielsweise für NMOS-Transistoren in einer 0,25µm-CMOS-Technologie ein Abstand DLJI von 0,4 µm als ausreichend erwiesen. Durch die Verwendung der sperrschichtisolierenden Wannenabschnitte 102A können vor dem TID-Effekt geschützte lineare MOS-Transistoren mit minimalen Kanalbreiten hergestellt werden, deren Ausmaße allein durch das jeweilige Skalierungsniveau der jeweiligen CMOS-Technologie bestimmt sind.

Es hat sich als vorteilhaft erwiesen, die Oberfläche O des aktiven MOS-Transistorgebiets 103 über dem jeweiligen sperrschichtisolierenden Wannenabschnitt 102A mit einer strukturierten Silizid-Blocker-Schicht 116 (schräge Schraffur mit großem Linienabstand in Fig. 1) aus einem elektrisch isolierenden Material zu bedecken. Sie ermöglicht die laterale Isolation der MOS-Kanalgebiete 110 und der Source-Gebiete 108, indem sie eine unerwünschte Silizidbildung an der Oberfläche in diesen Gebieten unterbindet.

Eine in Fig. 1 beidseitige Anordnung des Wannenanschlussgebiets 112 (vertikale Schraffur in Fig. 1) zu den Source-Gebieten 108 erzielt Vorteile bei der Unterdrückung von unerwünschten SET- und SEU-Effekten. Alle im Betrieb sperrgepolten Source-Gebiet 108 und Drain-Gebiete 109 des MOS-Transistors sind bei dieser Konstruktion nahe dem Wannenanschlussgebiet 112 angeordnet. Dies ermöglicht eine niederohmige Ableitung von SET-bedingten Majoritätsladungsträgerströmen aus dem Wannengebiet 102. Der damit erzielte geringe Anschlusswiderstand des Wannengebiets 102 hilft, SET-Ereignisse zeitlich besonders kurz zu halten und so die Wahrscheinlichkeit eines SEU-Effektes deutlich zu reduzieren.

Ein Wannenanschlussgebiet 113 bildet einen längsseitigen Abschluss des aktiven MOS-Transistor-Gebiets 103.

Fig. 1 zeigt auch anhand des Bezugszeichens 114 beispielhaft Kontaktstrukturen des MOS-Transistors 100 für die U-förmig ausgebildeten Wannenanschlussgebiet 112 und 113 und anhand des Bezugszeichens 118 beispielhaft Kontaktstrukturen für die Source-Gebiete 108 und die Drain-Gebiete 109.

Der MOS-Transistor 100 kann als NMOS- oder als PMOS-Transistor ausgeführt sein. Im Falle eines NMOS-Transistors ist typischerweise das Wannen-Gebiet 102 p-dotiert, während die Source-Drain-Gebiete 108, 109 stark n-dotiert und die Wannenanschlussgebiete 112 und 113 stark p-dotiert sind. Im Falle eines PMOS-Transistors ist typischerweise das Wannen-Gebiet n-dotiert, während die Source-Drain-Gebiete 108, 109 stark p-dotiert und die Wannenanschlussgebiete 112 und 113 stark n-dotiert sind.

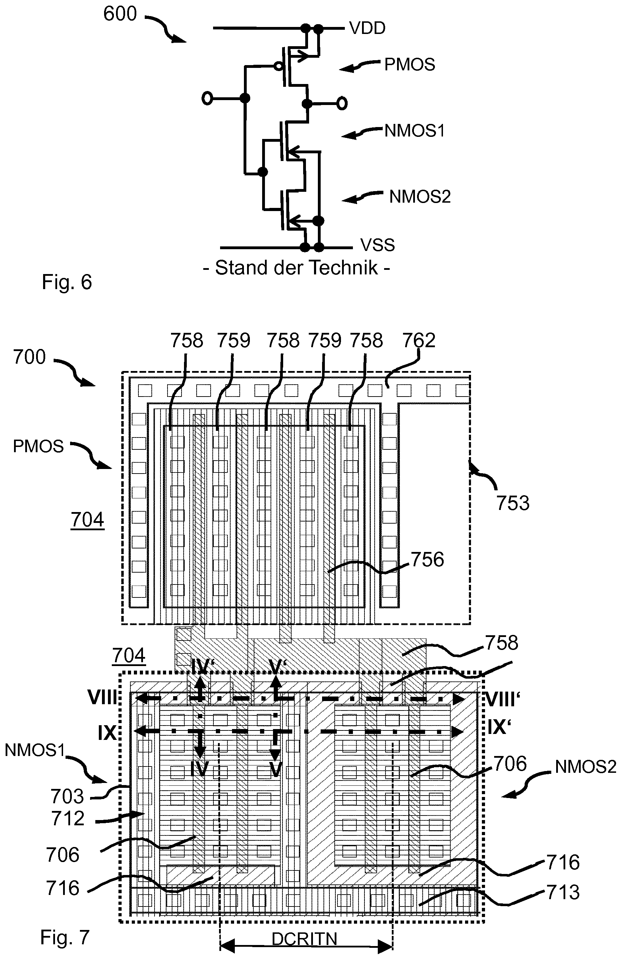

Konstruktionsprinzipien zur Verbesserung der Toleranz von integrierten digitalen CMOS Schaltungen gegenüber der Einwirkung von ionisierender Strahlung (TID Effekte) und schweren hochenergetischen Ionen (SET und SEU Effekte) werden nachfolgend, ohne eine Einschränkung des Anwendungsbereichs der Erfindung zu implizieren, am Beispiel eines CMOS-Inverters mit Bezug auf die Figuren 6 bis 9 erläutert.

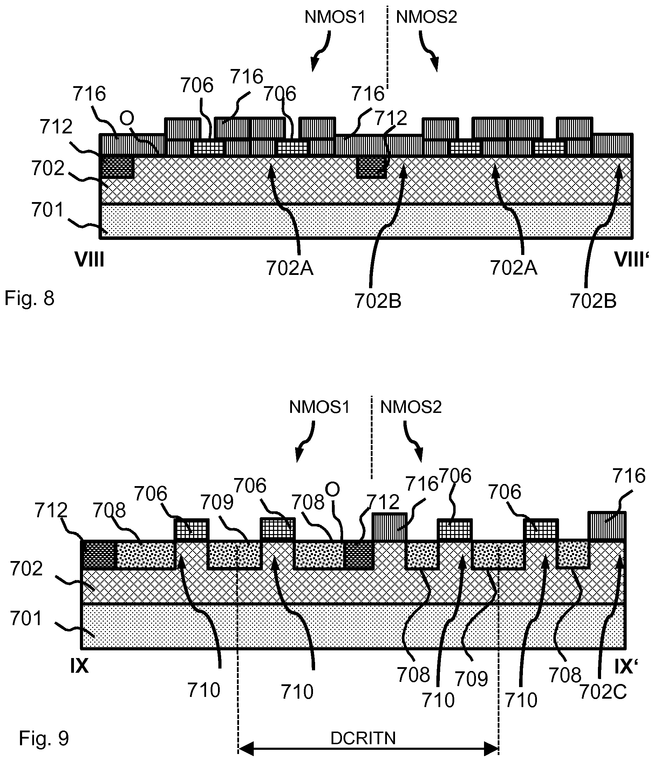

Fig. 6 zeigt ein für sich genommen bekanntes Schaltbild einer CMOS-Inverter-Schaltung zur Erläuterung des Ausführungsbeispiels der Fig.7. Fig. 7 zeigt ähnlich wie Fig. 1 eine Layoutansicht, hier eines Ausführungsbeispiels einer monolithisch integrierten MOS-Inverterschaltung. Fig. 8 zeigt eine Querschnittansicht des Ausführungsbeispiels der Figur 7 entlang der Linie VIII-VIII'. Fig. 9 zeigt eine Querschnittansicht des Ausführungsbeispiels der Figur 7 entlang der Linie IX-IX'.

Das Schaltbild der Fig. 6 veranschaulicht das Prinzip der Redundanz auf Transistorebene zur Vermeidung von Single-Event-Transienten in einem beliebigen NMOS-Pfad in einem CMOS-Gatter. Eine solche Schaltung eines strahlentoleranten CMOS Inverters mit Redundanz auf Transistorebene kann auch sowohl auf den NMOS- als auch den PMOS-Pfad des Inverters angewendet werden. Letzteres ist im vorliegenden Beispiel zwar nicht dargestellt, ist für den Fachmann jedoch an sich bekannt. Bei dem vorliegenden Beispiel einer Inverterschaltung 600 ist also ein einzelner PMOS-Transistor PMOS vorhanden. Anstelle eines einzelnen NMOS-Transistors in einer herkömmlichen Inverterschaltung ist vorliegend eine JICG-NMOS-Transistorstrukturmit zwei in Reihe geschalteten NMOS-Transistoren NMOS1 und NMOS 2 mit verbundenen Gates vorgesehen. Die auf diese Weise realisierte UND-Funktionalität für die Transistoren NMOS1 und NMOS2 ermöglicht die Aufrechterhaltung der Sperrfähigkeit im NMOS-Pfad bei einem Einschlag eines schweren hochenergetischen geladenen Teilchens in den Transistorgebieten von NMOS1 oder NMOS2.

In einer hier nicht dargestellten Variante wird also alternativ oder zusätzlich der PMOS-Transistor PMOS durch eine JICG-PMOS-Transistorstrukturmit zwei in Reihe geschalteten PMOS-Transistoren mit verbundenen Gates ersetzt. Die auf diese Weise realisierte UND-Funktionalität für die PMOS-Transistoren ermöglicht die Aufrechterhaltung der Sperrfähigkeit im PMOS-Pfad bei einem Einschlag eines schweren hochenergetischen geladenen Teilchens in den Transistorgebieten eines der beiden PMOS-Transistoren.

Fig. 7 zeigt das Layout eines CMOS Inverters 700, als Ausführungsbeispiel der Erfindung zur monolithischen Implementierung der Schaltung der Fig. 6. Das Layout des NMOS-Transistors NMOS1 entspricht dem anhand der Fig. 1 bis 5 vorgestellten Ausführungsbeispiel. Um die vorliegende Beschreibung knapp zu halten und auf die Wiederholung bereits oben gemachter Erläuterungen verzichten zu können, sind Bezugszeichen für Strukturelemente in den Fig. 7 bis 9 im Vergleich mit dem genannten Ausführungsbeispiel der Fig. 1 bis 5 nur in ihrer ersten Ziffer geändert, enthalten also vorliegend als erste Ziffer eine 7 statt einer 1, wenn ihre Struktur und Funktion der oben erläuterten entspricht. Somit kann zur Beschreibung der Strukturelemente der Fig. 7 bis 9 ergänzend auch auf die Beschreibung der Fig. 1 bis 5 zurückgegriffen werden.

Nachfolgend werden weitere Einzelheiten des CMOS-Inverters der Fig. 7 bis 9 erläutert.

Aktive Transistorgebiete 703 und 753 aus Silizium enthalten, wie in CMOS-Technologien allgemein üblich, N- und P-dotierte Wannen mit hoch dotierten Gebieten von Gates, Source-, und Drain- Gebieten und von Wannenanschlüsse mit den entsprechenden Kontakten.

Ein PMOS-Transistor (Bezugszeichen PMOS) ist im aktiven Gebiet 753 ausgebildet. Das aktive Gebiet ist lateral von einem flachen dielektrischen Isolationsgebiet (Feldisolationsgebiet) 704 umgeben, was hier graphisch nicht näher dargestellt ist. Das aktive Gebiet 753 enthält eine vierfingrige Gate-Struktur mit vier Gatestreifen unter Gate-Stapeln 756 zwischen P+-dotierten PMOS-Source- und Drain-Gebieten 758, 759. Ein N-Wannen-Anschlussgebiet 762 mit umgekehrter U-Form umgibt die Source-Drain-Gebiete im aktiven PMOS-Transistorgebiet an drei Seiten. Nur für den CMOS-Inverter 700 relevante Teile innerhalb des einen aktiven Gebiets 753 sind in Fig. 7 graphisch ausgeführt. Die eingezeichnete seitliche Begrenzung des aktiven Gebiets 753 auf seiner in der Draufsicht der Fig. 1 rechten Seite ist nur beispielhaft, sie ist nach Bedarf veränderbar.

Über eine Gate-Kontakt-Struktur 758 sind die Gate-Finger des PMOS-Transistors mit den Gate-Fingern der beiden redundanten NMOS-Transistoren NMOS1 und NMOS2 verbunden.

Die NMOS-Transistoren NMOS1 und NMOS2 sind vollständig in ein und demselben aktiven MOS-Transistorgebiet 703 aus Silizium angeordnet, welches wie das Beispiel der Fig. 1 bis 6 ein Wannengebiet 702, vorliegend ein n-Wannengebiet auf einem Substrat 701 hat. Eine laterale Isolation der MOS-Kanalgebiete 710 von NMOS1 und NMOS2 und der Source-Gebiete von NMOS2 wird durch die strukturierte Silizid -Blocker-Schicht 716 gewährleistet, die eine Silizidbildung in diesen Gebieten unterbindet. Diese Schicht wird auch als Salizid-Blocker-Schicht bezeichnet.

Die anhand von Fig. 1 bis 6 ausführlich erläuterten zusätzlichen Wannenabschnitte befinden sich vorliegend in beiden Transistoren NMOS1 und NMOS2 und sind mit den Bezugszeichen 702A, 702B und 702C gekennzeichnet. Die Längsschnitte der Figuren 4 und 4 sind auch für das vorliegende Ausführungsbeispiel gültig. Ihre Position ist daher in das Layout der Fig. 7 ebenfalls eingezeichnet. Diese Längsschnitte gelten auch für entsprechende Positionen des NMOS-Transistors NMOS2.

Die Drain-Gebiete 709 der hier lateral nebeneinander angeordneten NMOS-Transistoren NMOS1 und NMOS2 sind in einem Abstand DCRITN zueinander platziert. Der geometrische Abstand DCRITN der für SET-Ereignisse empfindlichen gesperrten pn-Übergänge in den Transistorgebieten von NMOS1 und NMOS2 ist dabei entscheidend für die Aufrechterhaltung der Sperrfähigkeit im NMOS Pfad. DCRITN ist im Layout geeignet zu wählen und sollte stets größer als der energieabhängige Wirkradius, der bei einem Teilcheneinschlag im Transistorgebiet von NMOS1 oder NMOS2 generierten Wolke von Elektronen/Löcher Paaren sein.

Am Beispiel einer 0,25µm CMOS-Technologie ist vorliegend ein Abstand von 4,5 µm vorgesehen.

Für mit der Anordnung gemäß Fig. 7 aufgebaute digitale CMOS-Schaltungen wurde in Bestrahlungstests mit Gamma-Strahlung mit einer Dosis von 1,5 Mrad ein Leckstrom-Niveau von weniger als 4 pA pro Gatefinger nachgewiesen. Das zum Vergleich bestimmte Leckstrom-Niveau von getesteten digitalen CMOS Schaltungen gemäß Stand der Technik war 2nA pro Gatefinger. Für mit einem Layout gemäß Fig. gefertigte digitale CMOS-Schaltungen wurden weiterhin in Bestrahlungstests mit schweren hochenergetischen Xenon-Ionen (¹³¹Xe+35 bei 1217MeV) keinerlei SET-Effekte bis zu den sehr hohen LET-Werten (LET: linear energy transfer) von 67,9 MeVcm²/mg beobachtet. Für mit einem Layout gemäß dem Stand der Technik hergestellte Standard-CMOS-Inverter wurden dagegen bereits bei LET < 10 MeVxcm²/mg Fehlfunktionen durch SET-Effekte detektiert.

Zusammenfassend wird also anstelle der üblichen lateralen dielektrischen Isolation des MOS-Kanals mittels STI oder LOCOS zusätzlich eine laterale Sperrschichtisolation des MOS-Kanals ausgebildet, welche Änderungen der Leitfähigkeit des MOS-Kanals durch die Influenzwirkung von verhafteten positiven Ladungen in der STI oder LOCOS Schicht durch TID Effekte vermeidet. Diese laterale Sperrschichtisolation wird erzeugt durch zusätzlich vorgesehene schmale laterale Wannenabschnitte im aktiven Siliziumgebiet zwischen dem MOS-Kanal und den lateralen STI- oder LOCOS-Isolationsgebieten. Zur Vermeidung von Kurzschlüssen an der Oberfläche des aktiven MOS-Transistorgebietes zu Source-Drain-Gebieten benachbarter MOS Transistoren werden dieses Wannenabschnitte vorzugsweise von einer strukturierten Silicid-Blocker-Schicht bedeckt.

Zur Vermeidung von SET- und SEU-Effekten sind in bevorzugten Anwendungsfällen jeweils zwei MOS-Transistoren gleichen Leitungstyps, die über eine gemeinsame Gate-Elektrode verfügen, in einer Reihenschaltung miteinander verbunden. Dabei wird der räumliche Abstand der sperrgepolten Drain-Gebiete der beiden Einzeltransistoren im Layout so eingestellt, dass dieser stets größer ist als der Wirkradius von zu betrachtenden Einschlägen schwerer energiereicher Ionen in das Siliziumgebiet der Transistoranordnung. Um kurze Zeiten für SET-Ereignisse zur Vermeidung von SEU-Ereignissen zu erhalten, ist die Konstruktion einer möglichst niederohmigen Verbindung der Wannengebiete mit VDD bzw. VSS notwendig. Dies wird dadurch erreicht, dass alle im Betrieb sperrgepolten Source-Drain-Gebiete der Transistoranordnung von den zugehörigen Wannengebieten umgeben sind, welche vollständig im aktiven Siliziumgebiet bis hin zur Oberfläche ausgebildet sind, und dass zwischen dem Drain-Gebiet des ersten Transistors und dem Source-Gebiet des zweiten Transistors der JICG-MOS-Transistorstruktur ein gemeinsames Wannenanschlussgebiet in der Breite der Source-Drain-Gebiete beider MOS Transistoren angeordnet ist. Die Source- und Drain-Gebiete der beiden in Reihe geschalteten und räumlich voneinander separierten MOS-Transistoren sind nicht einfach miteinander verschmolzen, sondern durch ein Wannengebiet räumlich voneinander getrennt und über eine metallische Leitbahn miteinander verbunden, was eine besonders niederohmige Ableitung der Wannenströme zur Unterdrückung von SET und SEU Effekten ermöglicht.

### Bezugszeichenliste

- 100: MOS-Transistor
- 101: Substrat102 Wannengebiet
- 102A: sperrschichtisolierender Wannenabschnitt
- 102B: sperrschichtisolierender Wannenabschnitt
- 103: aktives MOS-Transistor-Gebiet
- 104: dielektrische Isolationsschicht
- 106: Gate-Stapel
- 108: Source-Dotierungsgebiet
- 109: Drain-Dotierungsgebiet
- 110: MOS-Kanalgebiet
- 112: Wannenanschlussgebiet in gleicher Breite wie das Source-Gebiet des MOS Transistors, welches sich bis zur Oberfläche erstreckt, und unmittelbar neben dem Source-Gebiet zur niederohmigen Ableitung von generierten Wannenströmen nach VSS angeordnet ist
- 113: Wannen-Anschlussgebiet
- 114: Kontakt im Wannenanschlussgebiet
- 116: Salizidblocker-Schicht
- 600: CMOS-Inverter Schaltung mit Redundanz auf Transistorebene zur Vermeidung von SEU Effekten
- 700: Layout eines monolithisch Integrierten CMOS-Inverters mit JICG-N-MOS-Transistoranordnung zur Vermeidung von TID- und SEU Effekten
- 701: Substrat
- 702: Wannengebiet
- 702A: sperrschichtisolierender Wannenabschnitt
- 702B: sperrschichtisolierender Wannenabschnitt
- 702C: sperrschichtisolierender Wannenabschnitt
- 703: aktives NMOS-Transistor-Gebiet
- 704: dielektrische Isolationsschicht
- 706: NMOS-Gate-Stapel
- 708: NMOS-Source-Dotierungsgebiet
- 709: NMOS-Drain-Dotierungsgebiet
- 710: NMOS-Kanalgebiet
- 712: NMOS-Wannenanschlussgebiet in gleicher Breite wie das n+Source-Gebiet des NMOS-Transistors, welches sich bis zur Oberfläche erstreckt und unmittelbar neben dem n+Source-Gebiet zur niederohmigen Ableitung von generierten p-Wannenströmen nach VSS angeordnet ist
- 713: P-Wannen-Anschlussgebiet
- 716: Salizidblocker-Schicht
- 753: aktives PMOS-Transistorgebiet
- 756: PMOS-Gate-Stapel
- 758, 759: PMOS-Source-Drain-Gebiete
- 762: N-Wannen-Anschlussgebiet
- DCRITN: Abstand der NMOS-Transistoren
- DLJI, DLJI': Breiten des lateralen Sperrschichtisolationsgebiets in Längsrichtung
- DCH: Breite der Kanalgebiete in Längsrichtung
- PMOS: PMOS-FET
- NMOS1: NMOS-FET
- NMOS2: NMOS-FET

## Patentansprüche

1. Monolithisch integrierter MOS-Transistor (100), aufweisend
- ein dotiertes Wannengebiet (102) eines ersten Leitfähigkeitstyps;
- ein im Wannengebiet ausgebildetes aktives MOS-Transistor-Gebiet (103), mit dotierten Source- und Drain-Gebieten (108, 109) eines zweiten Leitfähigkeitstyps und mindestens einem MOS-Kanal-Gebiet (110), welches sich zwischen den Source-und Drain-Gebieten unter einem jeweiligen Gatestapel (106) erstreckt;
- eine an das aktive MOS-Transistor-Gebiet (103) angrenzende dielektrische Isolationsschicht (104) vom Typ STI oder LOCOS,
wobei
- Wannenabschnitte (102A, 102B) des Wannengebiets (102) in beiden einander entgegengesetzten lateralen Längsrichtungen (L1, L2), die senkrecht zu einer gedachten Verbindungslinie (V) weisen, welche vom Source- (108) durch das MOS-Kanal-Gebiet (110) zum Drain-Gebiet (109) reicht, an das MOS-Kanal-Gebiet (110) anschließen und bis zu einer Oberfläche (O) des aktiven MOS-Transistor-Gebiets (103) reichen, wodurch der an das MOS-Kanal-Gebiet (110) anschließende jeweilige Wannenabschnitt (102A, 102B) zwischen dem MOS-Kanal-Gebiet (110) und der dielektrischen Isolationsschicht (104) angeordnet ist,
**dadurch gekennzeichnet, dass**
die dielektrische Isolationsschicht (104) das aktive MOS-Transistor-Gebiet (103) lateral allseitig umgibt und
die Tiefenerstreckung der Wannenabschnitte (102A, 102B) stets größer als eine Tiefenerstreckung der angrenzenden dielektrischen Isolationsschicht (104) ist.

2. MOS-Transistor (100) nach Anspruch 1, bei dem eine laterale Ausdehnung (DLJI, DLJI') der Wannenabschnitte (102A, 102B) in Längsrichtung jeweils zwischen 10 und 500 Nanometer beträgt.

3. MOS-Transistor (100) nach Anspruch 1 oder 2, bei dem der Gatestapel und das MOS-Kanalgebiet in Längsrichtung geradlinig verlaufen.

4. MOS-Transistor nach mindestens einem der vorstehenden Ansprüche, bei dem mindestens ein zusätzlicher Wannenabschnitt (702C, 702D) des Wannengebiets (102) in Verlängerung der gedachten Verbindungslinie (V) vom Source-Gebiet (108) zum Drain-Gebiet (109) bis zur Oberfläche (O) des aktiven MOS-Transistor-Gebiets (103) reicht, wobei der zusätzliche Wannenabschnitt (702C, 702D) des Wannengebiets (102) zwischen dem Source-Gebiet (702) oder dem Drain-Gebiet (709) und der dielektrischen Isolationsschicht (104) angeordnet ist.

5. MOS-Transistor (100) nach mindestens einem der vorstehenden Ansprüche, bei dem die Oberfläche (O) des aktiven MOS-Transistorgebiets über dem jeweiligen Wannenabschnitt (102A, 102B) mit einer strukturierten Silizid-Blocker-Schicht (116) aus einem elektrisch isolierenden Material bedeckt ist.

6. Monolithisch integrierte MOS-Schaltung, welche mindestens einen MOS-Transistor gemäß mindestens einem der Ansprüche 1 bis 5 und mindestens ein weiteres monolithisch integriertes Bauelement aufweist.

7. JICG-MOS-Transistorstruktur, welche zwei in Reihe geschaltete MOS-Transistoren gleichen Leitungstyps gemäß mindestens einem der Ansprüche 1 bis 5 in einem gemeinsamen aktiven MOS-Transistor-Gebiet enthält, deren Gates miteinander verbunden sind, wobei die Source- Drain-Gebiete eines gemeinsamen Knotens der beiden MOS-Transistoren nicht in einem gemeinsamen hochdotierten Siliziumgebiet liegen, sondern durch das Wannengebiet voneinander isoliert sind und eine elektrische Verbindung der Source- und Drain-Gebiete des gemeinsamen Knotens über eine metallische Leitbahn erfolgt.

8. MOS-Schaltung, bei der die MOS-Transistoren der gemäß Anspruch 7 ausgebildet sind.

9. MOS-Schaltung nach Anspruch 8, bei der die JICG-MOS-Transistorstruktur sowohl ein erstes Wannenschlussgebiet an einem der Längsenden des Wannengebiets als auch ein zweites Wannenanschlussgebiet zwischen den Source- oder Drain-Gebieten eines ersten der beiden MOS-Transistoren und den Source- oder Drain-Gebieten eines zweiten der beiden MOS-Transistoren der JICG-MOS-Transistorstruktur aufweist.

10. MOS-Schaltung nach Anspruch 8 oder 9, bei dem in einem der MOS-Transistoren der JICG-MOS-Transistorstruktur ein zweiter zusätzlicher Wannenabschnitt (702D) des Wannengebiets (702) in Verlängerung der gedachten Verbindungslinie (V) vom Source-Gebiet (708) zum Drain-Gebiet (709) bis zu einer Oberfläche (O) des aktiven MOS-Transistor-Gebiets (703) reicht, wobei der zweite zusätzliche Wannenabschnitt (702D) des Wannengebiets (02) zwischen dem Source-Gebiet (108) oder dem Drain-Gebiet (109) und dem Wannenschlussgebiet angeordnet ist.

11. MOS-Schaltung nach mindestens einem der Ansprüche 8 bis 10, bei der die Drain-Gebiete der MOS-Transistoren der JICG-MOS-Transistorstruktur mit einem Abstand in Richtung der Verbindungslinie (V) von einander angeordnet sind, der mindestens zehn Mal größer ist als eine durch eine verwendete Herstellungstechnologie erzielbare vorbestimmte Mindestlänge des Kanal-Gebiets der MOS-Transistoren.

## Claims

1. Monolithically integrated MOS transistor (100), having:
- a doped well region (102) of a first conductivity type,
- an active MOS transistor region (103) formed in the well region, with doped source and drain regions (108, 109) of a second conductivity type and at least one MOS channel region (110) extending between the source and drain regions under a respective gate stack (106),
- a dielectric isolation layer (104) of the STI or LOCOS type adjacent to the active MOS transistor region (103),
wherein
- well portions (102A, 102B) of the well region (102) adjoin the MOS channel region (110) in the two opposite lateral longitudinal directions (L1, L2) oriented perpendicular to a notional connecting line (V) extending from the source region (108) through the MOS channel region (110) to the drain region (109), and said well portions extend as far as a surface (O) of the active MOS transistor region (103), so that the respective well portion (102A, 102B) adjoining the MOS channel region (110) is arranged between the MOS channel region (110) and the dielectric isolation layer (104),
**characterised in that**
the dielectric isolation layer (104) laterally surrounds the active MOS transistor region (103) on all sides, and
the depth of the well portions (102A, 102B) is always greater than a depth of the adjacent dielectric isolation layer (104).

2. MOS transistor (100) according to claim 1, in which a lateral extension (DLJI, DLJI') of the well portions (102A, 102B) in the longitudinal direction is between 10 and 500 nanometres.

3. MOS transistor (100) according to claim 1 or 2, in which the gate stack and the MOS channel region extend in a straight line in the longitudinal direction.

4. MOS transistor according to at least one of the preceding claims, in which at least one additional well portion (702C, 702D) of the well region (102) extends in extension of the notional connecting line (V) from the source region (108) to the drain region (109) as far as the surface (O) of the active MOS transistor region (103), said additional well portion (702C, 702D) of the well region (102) being arranged between the source region (702) or the drain region (709) and the dielectric isolation layer (104).

5. MOS transistor (100) according to at least one of the preceding claims, in which the surface (O) of the active MOS transistor region above the respective well portion (102A, 102B) is covered with a structured silicide blocker layer (116) made of an electrically insulating material.

6. Monolithically integrated MOS circuit which has at least one MOS transistor according to at least one of claims 1 to 5, and at least one further monolithically integrated component.

7. JICG MOS transistor structure, including two MOS transistors of the same conductivity type according to at least one of claims 1 to 5 and connected in series in a common active MOS transistor region, the gates of which are interconnected, and wherein the source/drain regions of a common node of the two MOS transistors are not in a common highly-doped silicon region, but are isolated from each other by the well region, and the source and drain regions of the common node are electrically connected via a metallic conductive path.

8. MOS circuit, in which the MOS transistors are formed according to claim 7.

9. MOS circuit according to claim 8, in which the JICG MOS transistor structure has not only a first well connection region at one of the longitudinal ends of the well region but also a second well connection region between the source or drain regions of a first of the two MOS transistors and the source or drain regions of a second of the two MOS transistors of the JICG MOS transistor structure.

10. MOS circuit according to claim 8 or 9, in which a second additional well portion (702D) of the well region (702) extends in one of the MOS transistors of the JICG MOS transistor structure in extension of the notional connecting line (V) from the source region (708) to the drain region (709) as far as a surface (O) of the active MOS transistor region (703), wherein the second additional well portion (702D) of the well region (02) is arranged between the source region (108) or the drain region (109) and the well connection region.

11. MOS circuit according to at least one of claims 8 to 10, in which the drain regions of the MOS transistors of the JICG MOS transistor structure are arranged at a distance from each other in the direction of the connecting line (V) that is at least ten times greater than a predetermined minimum length of the channel region of the MOS transistors which is achievable by any production technology used.

## Revendications

1. Transistor MOS (100) intégré de façon monolithique, comprenant :
- une zone de confinement dopée (102) d'un premier type de conductivité ;
- une zone de transistor MOS active (103) réalisée dans la zone de confinement, avec des zones de source et de drain (108, 109) d'un deuxième type de conductivité et au moins une zone de canal MOS (110), qui s'étend entre les zones de source et de drain, sous un empilement de grille (106) correspondant ;
- une couche d'isolation diélectrique (104), du type STI ou LOCOS, adjacente à la zone de transistor MOS active (103),
- les portions de confinement (102A, 102B) de la zone de confinement (102) se raccordant à la zone de canal MOS (110) et atteignant une surface (O) de la zone de transistor MOS active (103), dans les deux directions longitudinales (L1, L2), opposées entre elles, qui sont perpendiculaires à une ligne de liaison imaginaire (V), qui part de la zone de source (108), passe par la zone de canal MOS (110) et arrive à la zone de drain (109), la portion de confinement (102A, 102B) se raccordant à la zone de canal MOS (110) étant ainsi disposée entre la zone de canal MOS (110) et la couche d'isolation diélectrique (104),
**caractérisé en ce que**
la couche d'isolation diélectrique (104) entoure latéralement sur tous les côtés la zone de transistor MOS active (103) et
l'extension en profondeur des portions de confinement (102A, 102B) est toujours supérieure à une extension en profondeur de la couche d'isolation diélectrique (104) adjacente.

2. Transistor MOS (100) selon la revendication 1, dans lequel une extension latérale (DLJI, DLJI') des portions de confinement (102A, 102B) dans la direction longitudinale est dans chaque cas entre 10 et 500 nanomètres.

3. Transistor MOS (100) selon la revendication 1 ou 2, dans lequel l'empilement de grille et la zone de canal MOS s'étendent en ligne droite dans la direction longitudinale.

4. Transistor MOS selon au moins l'une des revendications précédentes, dans lequel au moins une portion de confinement supplémentaire (702C, 702D) de la zone de confinement (102) dans le prolongement de la ligne de liaison imaginaire (V) de la zone de source (108) vers la zone de drain (109) arrive jusqu'à la surface (O) de la zone de transistor MOS active (103), la portion de confinement supplémentaire (702C, 702D) de la zone de confinement (102) étant disposée entre la zone de source (702) ou la zone de drain (709) et la couche d'isolation diélectrique (104).

5. Transistor MOS (100) selon au moins l'une des revendications précédentes, dans lequel la surface (O) de la zone de transistor MOS est recouverte, au-dessus de la portion de confinement (102A, 102B) correspondante, avec une couche de blocage au siliciure structurée (116) constituée d'un matériau électro-isolant.

6. Circuit MOS intégré de façon monolithique, qui comprend au moins un transistor MOS selon au moins l'une des revendications 1 à 5 et au moins un autre composant intégré de façon monolithique.

7. Structure de transistor JICG-MOS, qui comprend deux transistor MOS de même type de conduction branchés en série, selon au moins l'une des revendications 1 à 5, dans une zone de transistor MOS active commune, dont les grilles sont reliées entre elles, les zones de source et de drain d'un noeud commun des deux transistors MOS ne se trouvant pas dans une zone de silicium hautement dopée commune, mais étant isolées entre elles par la zone de confinement, et une liaison électrique des zones de source et de drain du noeud commun ayant lieu par l'intermédiaire d'une piste conductrice métallique.

8. Circuit MOS dans lequel les transistors MOS sont conçus selon la revendication 7.

9. Circuit MOS selon la revendication 8, dans lequel la structure de transistor JICG-MOS comprend aussi bien une première zone de fermeture de confinement au niveau d'une des extrémités longitudinales de la zone de confinement qu'une deuxième zone de fermeture de confinement entre les zones de source ou de drain d'un premier des deux transistors MOS et les zones de source et de drain d'un deuxième des deux transistors MOS de la structure de transistor JICG-MOS.

10. Circuit MOS selon la revendication 8 ou 9, dans lequel, dans un des transistors MOS de la structure de transistor JICG-MOS, une deuxième portion de confinement supplémentaire (702D) de la zone de confinement (702) arrive, dans le prolongement de la ligne de liaison imaginaire (V) de la zone de source (708) à la zone de drain (709), à une surface (O) de la zone de transistor MOS active (703), la deuxième portion de confinement supplémentaire (702D) de la zone de confinement (02) étant disposée entre la zone de source (108) ou la zone de drain (109) et la zone de fermeture de confinement.

11. Circuit MOS selon au moins l'une des revendications 8 à 10, dans lequel les zones de drain des transistors MOS de la structure de transistor JICG-MOS sont disposées à une distance en direction de la ligne de liaison (V) entre elles, qui est au moins dix fois supérieure à une longueur minimale prédéterminée de la zone de canal des transistors MOS pouvant être obtenue par une technologie de fabrication utilisée.
